Europäisches Patentamt

(19) European Patent Office

Office européen des brevets

(11) Publication number: **0 051 133**
**A2**

(12) **EUROPEAN PATENT APPLICATION**

(21) Application number: **81107087.9**

(22) Date of filing: **09.09.81**

(51) Int. Cl.³: **H 01 L 31/14**

(30) Priority: **03.11.80 US 203040**

(43) Date of publication of application:
**12.05.82 Bulletin 82/19**

(84) Designated Contracting States:
**BE CH DE FR GB IT LI NL SE**

(71) Applicant: **International Business Machines Corporation**

**Armonk, N.Y. 10504(US)**

(72) Inventor: **Lanza, Conrad**
**Canopus Hollow Road**
**Putnam Valley, New York 10579(US)**

(72) Inventor: **Woodall, Jerry McPherson**
**336 Cherry Street**
**Bedford Hills New York 10507(US)**

(74) Representative: **Hobbs, Francis John**
**IBM United Kingdom Patent Operations Hursley Park**
**Winchester Hants, SO21 2JN(GB)**

(54) **Photon emitters and image converters comprising photon emitters.**

(57) A photon emitter which converts carriers from a low energy to a higher energy comprises a semiconductor body with a graded bandgap intrinsic conductivity region with an electric field impressed thereacross which causes electron or hole carriers under the influence of the electric field to move from a low energy gap region of the semiconductor body to a region that has a wider energy gap where recombination will produce a higher energy photon. The structure is useful in image conversion and electroluminescent detector applications.

FIG. 1

YO9-80-022                           1


PHOTON EMITTERS AND IMAGE CONVERTERS
COMPRISING PHOTON EMITTERS


This invention relates to photon emitters and image converters comprising photon emitters.


There has been effort to convert the wavelength of light. One of the most popular applications is that of converting the light of an image such as at dusk when it is invisible to the eye to light that is visible to the eye. Such structures are known as image converters and may be used to provide an amplification. A typical image conversion device emits electrons into a vacuum chamber when relatively low energy photons strike a photo cathode. The vacuum chamber has a high externally supplied electric field, requiring about 10,000 volts, which imparts kinetic energy to the electrons and drives them into a phosphor coating at the viewing portion of the device. The electrons give up energy to the phosphor causing it to emit a visible radiation. Focusing of the electrons is provided so that an image focused on the cathode is reproduced at a visible wavelength at the phosphor.


As uses for electrooptical conversion have expanded, it has become desirable to have light emitting diodes that emit at various desirable wavelengths. In these devices electron or hole carriers are injected into a semiconductor material having a bandgap such that radiative recombination of the carriers will be at the desired wavelength. In such structures, however, the dimensions and the performance are largely governed by the particular physical crystal properties of the semiconductor.


The invention provides a semiconductor photon emitter which finds an application in image converters.

A photon emitter comprises, according to the invention, a low conductivity semiconductor body having an input region at one end and an output region at the other end, a doped semiconductor region forming a junction with said output region, the doped region being sufficiently thin that the output region is disposed within optical transmission distance of an exposed surface, carrier introduction means to introduce electrical charge carriers into said input region and means to apply an electrical field along the semiconductor body of such a polarity that said electrical charge carriers move from said input region towards said output region, characterised by said output region having a larger energy gap than said input region.

An image converter comprises, according to the invention, a photon emitter as defined in the preceding paragraph, means to project an image in one waveband onto said input region and means to permit viewing of the image transformed to another waveband at said exposed surface of the body.

How the invention can be carried out will now be described by way of example, with reference to the accompanying drawings, in which:-

FIG. 1 is an illustration of a photon emitter embodying the invention.

FIG. 2 is a dimensionally correlated energy bandgap diagram of the device of FIG. 1.

FIG. 3 is a dimensionally correlated energy bandgap diagram of the device of FIG. 1 when under the influence of bias.

FIG. 4 is an illustration of an image converter employing the invention.

FIG. 5 is an illustration of an electroluminescent diode embodiment of the invention.

FIG. 6 is a dimensionally correlated energy diagram for one conductivity type material of the structure of FIG. 5, and

FIG. 7 is a dimensionally correlated energy diagram of the device of FIG. 5 using the opposite conductivity type material.

We have found that a semiconductor material can be provided with properties such that a low energy carrier present at a lower energy gap region can be moved to a higher energy gap region where a radiative recombination will cause emission of a photon of higher energy. The semiconductor material is provided with a region having a smaller bandgap in one portion, an electric field which causes a carrier to drift, in a time which is short compared to the lifetime of the carrier, to a different portion of the semiconductor which is so constructed as to have a set of conditions such that the bandgap will be wider and the electron will recombine radiatively and emit a high energy photon. The carrier may be introduced by lower energy photon irradiation or by electrical injection across a junction.

The invention may be applied to the fabrication of an image converter that is simpler and operates on a lower voltage than any heretofore in the art. The invention may also be applied to provide a brighter selectable output frequency solid state light emitter or light emitting diode. The low energy carrier can be introduced into the semiconductor either by the irradiating with an external source of low energy photons or in the alternative by an electrical injection of electrons or holes as appropriate in the low bandgap portion of the structure.

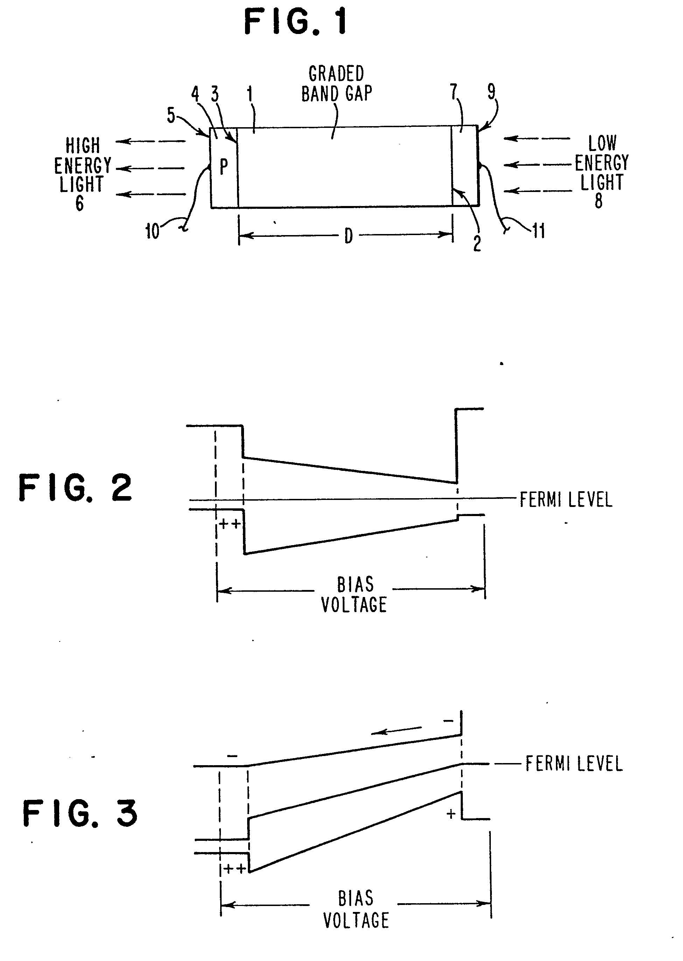

Referring to FIG. 1 a semiconductor body 1 is of low extrinsic conductivity or intrinsic semiconductor material and has a graded bandgap which is smaller in the vicinity of a surface 2 and increases to
a larger value in the vicinity of a junction 3 with a region of extrinsic
conductivity type material 4 that in turn is optically adjacent to a
surface 5. The distance D between the surface 2 and the junction 3 is
governed by the lifetime of the average carrier in the semiconductor
material and the magnitude of a bias impressed across the body 1 so that
a carrier appearing at 2 can reach the junction 3 during its lifetime.
Since a bias is impressed across the body 1, the semiconductor material
should be of low extrinsic conductivity or preferably intrinsic to
minimize current flow. Further, the lower the extrinsic conductivity,
the higher the lifetime and the less stringent the dimension D will be.

In the structure of FIG. 1 a carrier having a first energy will be
moved under the influence of bias to a portion of the body 1 having a
higher energy gap where a radiative recombination can take place at the
junction 3 emitting a high energy photon shown as light 6 which passes
through the relatively thin extrinsic conductivity type region 4 illustrated as P, and emerges through the surface 5. The thickness of the
region 4 should be such that a radiative recombination occurring at the
junction 3 will have the light therefrom minimally attenuated before
emerging from the surface 5 as light 6.

Considering an illustrative specific example. If the body 1 is
formed such that the portion of the body 1 in the vicinity of the
surface 2 is of gallium arsenide and the portion of the body 1 in the
region of the junction 3 is of aluminum arsenide with a relatively
linear grading of x in the expression $Ga_x Al_{1-x} As$ between, there will be
a 1.4 electron volt bandgap at the surface 2 and a 2.16 electron volt
bandgap at the junction 3. Such a structure will have a direct bandgap
for an aluminum content up to about 35%. Beyond this level to the point
where it becomes pure aluminum arsenide, the material will have an
indirect bandgap. The indirect bandgap portion, however, does not have a significant effect since most recombination takes place at the junction 3 and little recombination takes place in the intrinsic portion of the body.

A region 7 such as AlAs, is provided to prevent surface recombination of the carriers introduced by low energy light 8 focused through the surface 9 to the surface 2. The region 7 has a wider bandgap than the body 1 adjacent to the surface 2. Ohmic contacts 10 and 11 are provided to apply a bias across the device thereby providing an electric field between the surface 2 and the junction 3.

The dimension D from the surface 2 to the junction 3 for the material $Ga_{(1-x)}Al_xAs$ is of the order of 10 micrometers. The p region 4 is very thin, about 1 micrometer, is doped to about $10^{17}$, and is of aluminum arsenide with a bandgap of about 1.85 electron volts. The surface recombination control region 7 of AlAs has a bandgap of 2.16 electron volts, is about 1 micrometer thick and is epitaxial with the GaAs portion of the body 1. The GaAs portion of the body 1 at the junction 2 has a bandgap of 1.4 electron volts.

The device is irradiated from a source of light shown as arrows 8 of low energy photons through the surface 9 and the surface recombination control region 7 to the surface 2.

Referring next to FIG. 2 the conditions of the invention are illustrated in terms of an energy level diagram wherein the wide bandgap in region 4 of FIG. 1 abruptly shifts across the junction 3 and then narrows relatively linearly through the body 1 along the distance D to a narrower value adjacent the surface 2 where it abruptly again widens in the surface recombination control region 7.

In FIG. 3 the influence of bias on the energy level diagram is illustrated. The effect of the bias is to shift the levels such that for the type of carriers illustrated (electrons) an electron appearing at the surface 2 is caused by the bias to move in the direction of the junction 3 where a radiative recombination with a hole at the junction occurs at a higher bandgap and a higher energy photon is generated.

In the particular illustration of $Ga_{1-x}Al_xAs$, under these conditions when low energy radiation as shown by arrows 8 impinges on the surface 9 and penetrates through the region 7 to the surface 2, electrons with an energy in the vicinity of 1.4 electron volts are produced. As seen in FIG. 3 the electric field provides a force to the electrons which drift farther and more rapidly in the direction of the junction 3 where they recombine radiatively with holes. Since this recombination takes place at a position in the structure where the bandgap is 1.85 electron volts, photons of that energy are emitted.

The regenerative recycling of photons is enhanced in the device of this invention. The regenerative recycling of photon phenomenon is described in the Journal of Applied Physics, 50, (10) October 1979, page 6353. In that device photons created by radiative recombination of carriers near a p-n junction are reabsorbed when they travel in a direction of lower bandgap energy material. The reabsorbed photons generate new excited carriers which recombine emitting photons of lower energy than the absorbed photons. By contrast, in the device of the present invention any emitted photon at the junction 3 can emerge from the semiconductor as light 6 through the surface 5. If, however, when a photon is formed at the junction 3, it moves away from the junction 3 in the direction of the surface 2, the photon then becomes absorbed in the intrinsic material and another hole electron pair is produced. The electron of this pair, in turn, is enhanced in recycling by the field and the electron is caused to drift strongly in the direction of the junction 3 where a radiative recombination forms another high energy photon. Such a recycling process is repeated until the photon emerges or the electron finds a recombination that is non-radiative. The result of this structure is a very efficient light emitter.

The bias voltage should be sufficient to move the electron all the way in the direction of the junction 3 within its lifetime. The bias voltage, however, should not be so high that excessive joule heating will result.

It is desirable to create a field intensity sufficient to cause the electron to drift the distance D, which in this example is 10 microns, in a time short compared to the lifetime of the electron.

Assuming, for example, intrinsic $Ga_{(1-x)}Al_x As$ material as the body 1, the lifetime of an electron will be about $1x10^{-8}$ seconds and such an electron will drift through the 10 micron distance D in approximately $1x10^{-9}$ seconds requiring a velocity of $1x10^6$ centimeters per second. Since the mobility of electrons is about 5000 $cm^2$ per volt-second, the electric field will be governed by the expression:

Equation 1:    $E = \dfrac{v}{u}$    where v is the velocity
                      in cm/sec. and u is the
                      electron mobility.

                $E = 200$   volts/centimeter.

For the 10 micron thickness the required voltage which would be governed by expression of Equation 2.

Equation 2:    $V = Exd$   where E is the field
                      and d is the distance.

                $V = Exd = $   0.2 volts.

In view of the fact that the conduction band edge as set forth in FIG. 2 had an initial gradient of approximately 0.2 volts in the 10 microns, then a total of 0.4 volts would be required across the intrinsic portion 1 of the device.  Since the intrinsic material has a very high resistance and the voltage applied is very low, there will be small joule heating.

It will be apparent to one skilled in the art that in addition to the example of $Ga_{1-x}Al_xAs$, a selection of dimensions and output light frequency could be obtained by application of the invention by properly selecting lattice-matched material combinations.  It has been established in the art that there is a correlation between lattice constant and band energy level.

A listing of a series of example lattice-matched elements with the respective bandgaps appears in TABLE I.

<div align="center">

TABLE I

LATTICE-MATCHED SEMICONDUCTORS

</div>

| Material | Range of X Bandgap | Direct Range |
|---|---|---|
| $(InSb)\ (InAs)_{1-x}(InSb)_{.5x}$ | 0 - 1 | 0.15-1.2 ev |
| $Al_xGa_{1-x}As$ | 0 - 1 | 1.4 -1.85 |
| $(ZnSe)_x\ (GaAs)_{1-x}$ | 0 - 1 | 1.4 -2.25 |
| $(AlSb)_x\ (GaSb)_{1-x}$ | 0 - 0.4 | 0.72-1.2 |
| $(InP)_x\ (InAs)_{1-x}$ | 0 - 1 | 0.35-1.35 |

Each component listed in TABLE I can, with appropriate doping be made intrinsic or with either p and n extrinsic type conductivity with two exceptions. The exceptions are that the material InSb can only be made intrinsic and the material ZnSe cannot be doped p type.

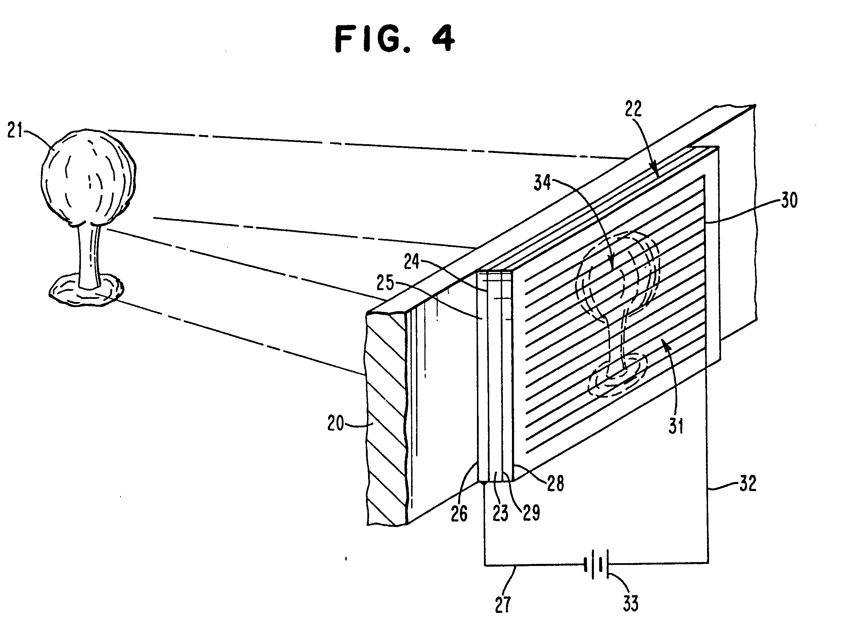

Referring next to FIG. 4 wherein the photon emitter described with reference to FIG. 1 is embodied in a solid state image converter.

In FIG. 4 a transparent substrate 20 is provided which will not seriously attenuate the low energy light which is shown as dotted lines emanating from an object 21. On the opposite surface of the substrate 20 from the object 21, the structure of FIG. 1 is positioned. The structure is a monocrystalline member 22 having a graded energy gap intrinsic region 23 with the low energy gap portion at a surface 24 which is contiguous with a surface recombination control region 25. A fine electrical grid is placed on the surface 26 of the region 25 in contact with the substrate. The grid should be either transparent or occupy in the vicinity of 3% of the area and be electrically connected to electrical lead 27. A p conductivity type region 28 forms a junction 29 with the high bandgap energy portion of the region 23. An electrical grid 30 is applied to the surface 31 and is connected to an electrical lead 32. A bias is applied across the region 23 by connecting the leads 27 and 32 to a battery 33.

In operation the low energy photons from the image 21 pass through the substrate and produce carriers at the low energy portion of the graded bandgap region 23. The carriers are moved by the bias field to the junction 29 where they recombine radiatively at a higher energy and an image 34 appears on the surface 31 at a wavelength that is more readily visible than that of the image 21.

In order to assist one skilled in the art, the following specifications are provided for the structure of FIG. 4.

Assuming an area of about 1 sq. centimeter for the device, the substrate 20 can be $Al_2O_3$ about 1 millimeter thick. Vapor deposited aluminum ohmic grid contacts covering about 3% of the area are formed both on the face 31 and on the face 26. All other dimensions are as set forth as for $Ga_{(1-x)}Al_xAs$ example in connection with FIG. 1. The bias from battery 33 is about 0.4 volts.

When an object such as 21, illuminated in infrared having a 1.4 electron volt energy, is brought into focus on the substrate 20, a red 1.85 electron volt image will be formed on the face 31. The quality of the image will be somewhat affected by the thickness of the device and the shorter the distance D (FIG. 1) that will provide a good drift field, the clearer the image.

The principle of the invention may also be applied where the carriers are electrically injected into the field driven graded energy gap material.

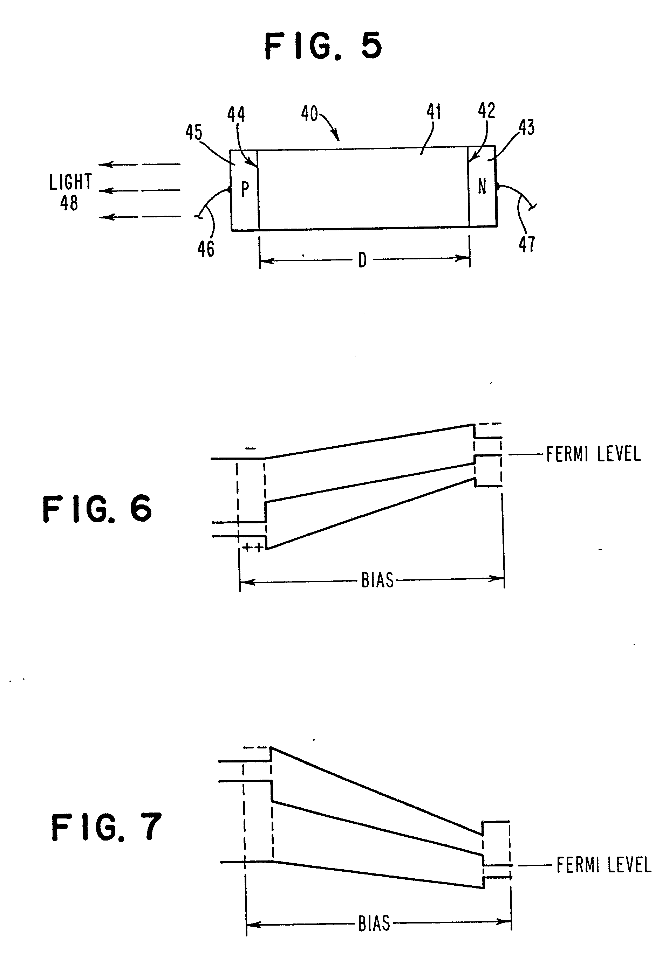

Referring now to FIG. 5 a body 40 having a graded energy gap and high extrinsic or preferably intrinsic conductivity type and consisting of any of the materials of TABLE I except for zinc selenide, is provided with a graded energy gap region 41 having a lower energy gap at a junction 42 with an n conductivity type region 43 and a higher energy gap at a junction 44 with a p conductivity type region 45. A bias voltage is provided through contacts 46 and 47 which operates to inject carriers at the junction 42 into the lower energy gap portion of the intrinsic region 41 where they drift under the influence of the bias field to recombine at the junction 44. The radiative recombination results in higher intensity photons escaping as light shown as arrows 48.

The energy level conditions are as set forth in the energy diagram of FIG. 6 wherein electrons are injected at the interface corresponding to the junction 42 of FIG. 5.

The energy level diagram of FIG. 7 is applicable in the case of a material such as zinc selenide, or in a situation where carrier types are reversed.  In FIG. 7.  In this case, holes are injected at the junction 42 and are caused to drift where they recombine radiatively with electrons at the junction 44.

The photons from the radiative recombination are represented by arrows 48 emanating from the p region 44.  The illumination 48 is brighter due to the enhanced recycling feature which adds the photons which would normally be lost due to absorption by the semiconductor. This may be contrasted with a standard p-intrinsic-n light emitting diode wherein the I region does not have a graded bandgap.

In operation, either the device of FIG. 1 or the device of FIG. 5 can be combined with conventional detectors such as charge-coupled devices or silicon diodes.

What has been described is a solid state energy converting structure wherein carriers are introduced into the lower energy gap portion of a graded energy gap region and which are caused by a drift field to move to a region of higher energy gap where they radiatively recombine. The structure of the invention is a solid state energy converter which takes a low energy carrier and converts it to a photon of a higher energy.

CLAIMS

1.    A photon emitter comprising a low conductivity semiconductor body having an input region (7) at one end and an output region at the other end, a doped semiconductor region (4) forming a junction with said output region, the doped region being sufficiently thin that the output region is disposed within optical transmission distance of an exposed surface (5), carrier introduction means to introduce electrical charge carriers into said input region and means to apply an electrical field along the semiconductor body of such a polarity that said electrical charge carriers move from said input region towards said output region, characterised by said output region having a larger energy gap than said input region.

2.    A photon emitter as claimed in claim 1, wherein said low conductivity body consists of an intrinsic semiconductor.

3.    A photon emitter as claimed in claim 2, wherein said semiconductor body consists of $Ga_{1-x}Al_xAs$ graded from a lower energy gap at said input region to a higher energy gap at said output region.

4.    A photon emitter as claimed in claim 3, wherein said low conductivity body is 10 microns long.

5.    A photon emitter as claimed in claim 4, wherein said electrical field is applied by a bias of 0.4 electron volts between said input and output regions.

6.    A photon emitter as claimed in any preceding claim, wherein said carrier introduction means is light.

7.    Image converter comprising a photon emitter as claimed in claim 6, means to project an image in one waveband onto said input region and means to permit viewing of the image transformed to another waveband at said exposed surface of the body.

8.    A photon emitter as claimed in any preceding claim, wherein said carrier introduction means is by electrical injection.

# FIG. 1

GRADED
BAND GAP

HIGH
ENERGY
LIGHT
6

LOW
ENERGY
LIGHT
8

P

D

# FIG. 2

FERMI LEVEL

++

BIAS
VOLTAGE

# FIG. 3

FERMI LEVEL

++

+

BIAS
VOLTAGE

# FIG. 4

# FIG. 5

LIGHT 48

P | N | D

# FIG. 6

FERMI LEVEL

BIAS

# FIG. 7

FERMI LEVEL

BIAS